# FASCICULE DE BREVET EUROPEEN

(11) **EP 3 083 487 B1**
(45) Date de publication et mention de la délivrance du brevet: **08.01.2020**
(21) Numéro de dépôt: 14827755.1
(22) Date de dépôt: 19.12.2014
(51) Int. Cl.: B81C 99/00, G04D 3/00, G04B 15/14, G04B 17/06, G04B 19/04

(54) **PROCÉDÉ DE FABRICATION D'UN COMPOSANT HORLOGER**
VERFAHREN ZUR HERSTELLUNG EINER UHRENKOMPONENTE
METHOD FOR MANUFACTURING A TIMEPIECE COMPONENT

(30) Priorité: 20.12.2013 EP 13198950
(43) Date de publication de la demande: 26.10.2016
(60) Demande divisionnaire: 19208806.0
(73) Titulaire: ROLEX SA, 1211 Genève 26 (CH)
(72) Inventeur: BOSSART, Richard, 1004 Lausanne (CH); MICHELET, Edward, 2502 Bienne (CH)
(74) Mandataire: Moinas & Savoye SARL
(86) Numéro de dépôt international: PCT/EP2014/078857
(87) Numéro de publication internationale: WO 2015/092012

(56) Documents cités:
- EP-A1- 0 732 635
- EP-A1- 2 145 857
- WO-A1-2013/093108

## Description

La présente invention concerne un procédé de fabrication d'un composant horloger réalisé à partir d'un matériau micro-usinable.

Il est connu de fabriquer des composants horlogers à partir d'un matériau micro-usinable tel que le silicium et par des techniques issues de la microélectronique, notamment par gravure ionique réactive profonde (en anglais *Deep Reactive Ion Etching DRIE*)*.* Le procédé de fabrication comprend généralement les étapes suivantes :
- se munir d'une plaque en matériau micro-usinable, par exemple en silicium,
- former le composant horloger, par gravure à travers la totalité de l'épaisseur de la plaque,
- libérer le composant en le séparant du reste de la plaque.

L'utilisation de matériaux et de techniques de fabrication issues de la microélectronique offre des possibilités très intéressantes, notamment en termes de précision. Une difficulté à surmonter est toutefois de libérer le composant, sans l'endommager. Généralement, des attaches, ou ponts de matière, sont prévues entre le composant horloger et le reste de la plaque. Ces attaches ont pour rôle de maintenir la pièce solidaire de la plaque pendant toute la fabrication du composant, notamment pendant des traitements appliqués au composant après la gravure (traitement thermique, dépôt d'un revêtement, etc.), tout en facilitant la libération du composant en fin de fabrication.

Le document EP2145857 décrit un procédé de fabrication d'un composant horloger analogue à celui décrit ci-dessus. Des ponts de matière sont gravés et maintiennent le composant solidaire de la plaque pendant les différentes étapes de fabrication du composant horloger. Afin de faciliter la libération du composant en fin de fabrication, les ponts de matière comportent une section rétrécie à l'extrémité reliée au composant. Cela permet de créer une zone de faiblesse facilitant la rupture des ponts de matière. En fin de fabrication, le composant horloger est libéré de la plaque par rupture fragile du matériau au niveau des attaches, ou ponts de matière, en réponse à une sollicitation mécanique adaptée.

La casse du matériau par rupture fragile entre le pont de matière et le composant est difficilement contrôlable.

Le document WO2013/093108 décrit un procédé de fabrication d'une pièce micromécanique à partir d'une plaque en un matériau micro-usinable, des attaches étant ménagées entre la pièce et la plaque. Ces attaches sont affaiblies localement par amincissement pour créer des articulations. Celles-ci sont adaptées pour permettre un détachage du composant par un effort de torsion dans le plan de la plaque. Il en résulte une rupture entre la pièce et la plaque qui manque de précision. L'endroit de la rupture n'est pas précisément déterminable a priori. Elle sera située le long de l'attache affaiblie, sans qu'il soit possible de savoir à l'avance si elle sera proche de la pièce ou de la plaque. Cela peut s'avérer gênant tant sur le plan fonctionnel qu'esthétique. De plus, pour libérer la pièce par torsion dans le plan de la plaque, il faut prévoir de la place autour de la pièce pour permettre un déplacement relatif de la plaque et de la pièce. Cela oblige à réduire le nombre de pièces fabriquées à partir d'une plaque.

La présente invention vient améliorer la situation.

A cet effet, l'invention concerne un procédé de fabrication d'un composant horloger selon la revendication 1.

L'invention consiste à former une zone de pré-détachage le long d'une ligne de rupture précisément déterminée. Une ou plusieurs ouvertures sont gravées dans l'épaisseur de la plaque afin de créer une zone de plus faible résistance mécanique, correspondant à la zone de pré-détachage, et d'amorcer la rupture à l'endroit souhaité, le long de la ligne de rupture souhaitée.

Le composant horloger peut être obtenu par gravure de la plaque dans toute son épaisseur. Autrement dit, on grave dans ce cas une ou plusieurs ouvertures traversantes dans la plaque pour former le composant.

Dans un mode de réalisation particulier, ladite ouverture est obtenue par gravure d'une partie de l'épaisseur de la plaque.

Selon un premier mode de réalisation, ladite ouverture s'étend le long de la totalité de la ligne de rupture.

Selon un deuxième mode de réalisation, la zone de pré-détachage comporte une pluralité d'ouvertures alignées le long de la ligne de rupture.

La longueur des ouvertures peut être comprise par exemple entre 2 et 10 µm.

En définitive, la zone de pré-détachage peut comprendre une seule ouverture s'étendant tout le long de la ligne de rupture, ou plusieurs ouvertures alignées le long de la ligne de rupture et séparées par des ponts. En toute hypothèse, la surface de rupture obtenue après libération du composant horloger de la plaque est beaucoup plus propre qu'avec une attache standard. En outre, on limite le risque de créer des amorces de fissure dans le composant.

Avantageusement, la profondeur de l'ouverture est inférieure ou égale à 90% de l'épaisseur de la plaque, préférentiellement inférieure ou égale à 60% de ladite épaisseur.

Avantageusement encore, la profondeur de l'ouverture ou des ouvertures est supérieure ou égale à la moitié de l'épaisseur de la plaque.

La largeur de la ou des ouvertures peut être comprise entre 1 et 10 µm, notamment entre 1 et 5 µm.

Dans un mode de réalisation particulier, la gravure du composant horloger et la gravure de l'ouverture de la zone de pré-détachage sont réalisées de façon simultanée.

Dans ce cas, la largeur de ladite ouverture de la zone de pré-détachage est avantageusement inférieure à la largeur d'une ouverture traversante destinée à former le composant horloger, notamment inférieure à la plus petite des largeurs d'une pluralité d'ouvertures traversantes formant le composant horloger.

Dans un mode de réalisation particulier, la largeur d'ouverture traversante destinée à former le composant étant supérieure à 40 µm, la largeur ladite ouverture de la zone de pré-détachage est comprise entre 1 et 10 µm, notamment entre 1 et 5 µm.

Une telle largeur de l'ouverture de pré-détachage favorise un détachement du composant provoqué par une sollicitation mécanique selon une direction perpendiculaire au plan de la plaque, qui est très simple et pratique à mettre en œuvre.

Avantageusement, la gravure du composant horloger et la gravure de l'ouverture de la zone de pré-détachage sont réalisées par gravure ionique réactive profonde.

Dans un autre mode de réalisation, la gravure de l'ouverture de la zone de pré-détachage et la gravure du composant horloger sont réalisées séparément, respectivement au moyen d'impulsions laser femtosecondes et par gravure ionique réactive profonde .

Le matériau de la plaque peut être un matériau fragile, notamment l'un des matériaux du groupe comportant le silicium, le diamant, le quartz et la céramique.

Avantageusement, il comprend une étape de libération du composant horloger par casse ou rupture de l'attache le long de la ligne de rupture.

Avantageusement, lors de l'étape de libération du composant horloger, on provoque la rupture en exerçant sur l'attache une force mécanique selon une direction présentant un angle inférieur ou égal à 45° par rapport à une direction perpendiculaire à la plaque, notamment inférieur ou égal à 30° par rapport à une direction perpendiculaire à la plaque, préférentiellement selon une direction perpendiculaire, ou sensiblement perpendiculaire, à la plaque.

Grâce à cela, la libération du composant horloger est simple et pratique à mettre en œuvre. En outre, elle ne nécessite pas de laisser de la place autour des composants. Il est donc possible d'optimiser l'utilisation de la plaque pour fabriquer autant de composants que possible à partir de celle-ci.

Le composant horloger peut être l'un des éléments du groupe comportant un spiral, une roue, une aiguille, un ressort, une ancre et un balancier.

L'invention concerne aussi une plaque en matériau micro-usinable comportant un composant horloger et au moins une attache de maintien entre le composant horloger et le reste de la plaque, formés par des ouvertures gravées dans l'épaisseur de la plaque, caractérisée par le fait qu'elle comprend une zone de pré-détachage du composant horloger comportant, le long d'une ligne de rupture souhaitée de l'attache, au moins une ouverture gravée dans l'épaisseur de la plaque.

L'invention sera mieux comprise à l'aide de la description suivante de différents exemples de réalisation du procédé de fabrication d'un composant horloger, d'une plaque de matériau micro-usinable intégrant un composant horloger et d'un composant horloger selon l'invention, en référence aux dessins annexés sur lesquels :
- les figures 1A, 1B et 1C représentent respectivement une vue de dessus et une vue en coupe (dans le plan yz) d'une attache entre un composant horloger et une plaque de matériau micro-usinable, et une vue partielle du composant horloger, de la plaque et de l'attache, selon une première forme de réalisation ;
- la figure 2 représente une vue d'un pont de matière entre un composant horloger et une plaque de matériau micro-usinable, selon l'art antérieur ;
- la figure 3 représente une vue de dessus d'un pont de matière entre un composant horloger et une plaque de matériau micro-usinable, selon une forme de réalisation analogue à celle des figures 1A et 1B ;
- la figure 4 représente une vue de dessus d'un pont de matière entre un composant horloger et une plaque de matériau micro-usinable, selon une deuxième forme de réalisation ;
- la figure 5 représente une vue de dessus d'un pont de matière entre un composant horloger et une plaque de matériau micro-usinable, selon une variante de la deuxième forme de réalisation ;
- la figure 6 représente une vue agrandie et partielle d'une zone de pré-détachage d'un pont de matière selon une variante de la deuxième forme de réalisation ;
- les figures 7A et 7B représentent des zones de rupture respectivement d'un composant horloger selon l'art antérieur et d'un composant horloger selon la première forme de réalisation ;
- la figure 8 représente un autre exemple illustratif d'une surface de rupture obtenue par la mise en œuvre du procédé de l'invention,
- la figure 9 représente un organigramme des étapes du procédé de fabrication, selon un mode de réalisation particulier ;
- les figures 10A à 10F représentent une vue de détail de la zone de pré-détachage d'une attache entre un composant horloger et une plaque de matériau micro-usinable, selon une première forme de réalisation (figures 10C et 10D), une deuxième forme de réalisation (10E et 10F) et selon une autre forme de réalisation (10A et 10B).

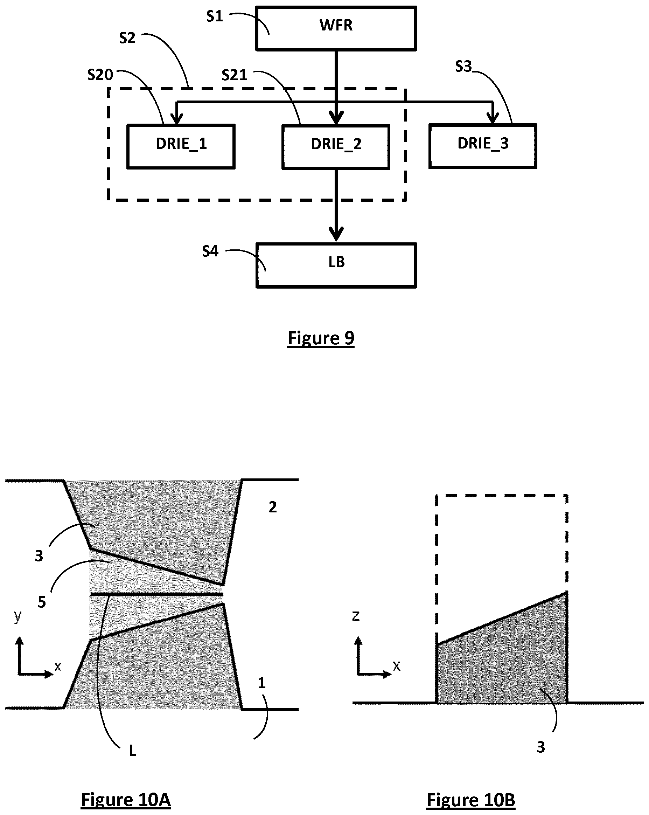

En référence à la figure 9, le procédé de l'invention comprend principalement quatre étapes S1, S2, S3 et S4 destinées à fabriquer un composant horloger 1 à partir d'un matériau micro-usinable.

Par matériau « micro-usinable », on entend désigner tout matériau adapté pour le micro-usinage. Selon le dictionnaire professionnel illustré de l'horlogerie Berner, le micro-usinage désigne « *l'ensemble des techniques issues de la microélectronique (attaques chimiques, photolithographie, déposition de couches minces en phase vapeur, etc.), additionné d'autres techniques permettant l'usinage d'une vaste gamme de matériaux tels que semiconducteurs, céramiques, métaux, certains polymères, etc.* ». Le matériau micro-usinable utilisé dans les exemples de réalisation décrits ci-après est le silicium. D'autres matériaux micro-usinables pourraient évidemment être utilisés à la place, comme par exemple le diamant, le quartz et la céramique.

L'étape S1 consiste à se munir d'une plaque 2 de matériau micro-usinable, ici une plaquette (ou « wafer ») de silicium, analogue à celles utilisées pour la fabrication de composants microélectroniques. La plaquette a par exemple une épaisseur de 150 µm. Bien évidemment, on peut utiliser d'autres épaisseurs de plaquette.

L'étape S2 consiste à former dans la plaque un composant horloger 1 et une ou plusieurs attaches 3 de maintien du composant 1 au reste de la plaque 2. Le composant horloger 1 et ses attaches 3 sont réalisés de façon simultanée, respectivement lors de sous-étapes référencées S20 (« DRIE_1 ») et S21 (« DRIE_2 »), par photolithographie suivie d'une gravure ionique réactive profonde. Lors de ces étapes S20 et S21, on grave dans la plaque 2, ici dans toute son épaisseur, des parties autour du composant 1 et des attaches 3. Autrement dit, on grave dans la plaque 2 un motif composé d'ouvertures traversantes, les formes de celles-ci étant adaptées pour former le composant 1 et ses attaches 3.

En variante, pour former le composant horloger, on pourrait utiliser une plaque formée de plusieurs couches, par exemple une plaque SOI formée de deux couches en Si prenant en sandwich une couche en SiO2, où l'une des couches en Si est utilisée pour former le composant, et l'autre couche en Si est utilisée comme support. Dans un tel cas, on entend par « ouverture traversante » une ouverture qui traverse toute la couche en Si dans laquelle est formée le composant, et non une ouverture qui traverse toute la plaque SOI.

Le rôle des attaches 3 est de maintenir le composant horloger 1 solidaire de la plaque 2 pendant la fabrication et de permettre une libération du composant horloger 1, par rupture de l'attache 3, en fin de fabrication. Les attaches 3 sont des ponts de matière entre le composant horloger gravé 1 et le reste de la plaque 2. Elles peuvent avoir des formes variées.

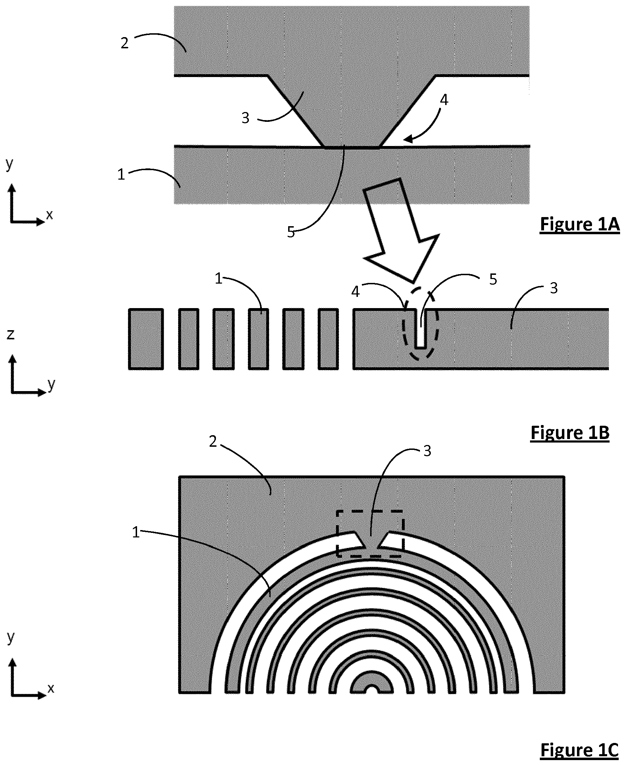

Par définition, on appelle « longueur » d'une attache, la dimension de l'attache selon une direction longitudinale reliant les milieux des deux extrémités de liaison de l'attache (respectivement au reste de la plaque 2 et au composant 1), dans le plan de la plaque 2 (c'est-à-dire un plan parallèle aux surfaces supérieure et inférieure de la plaque, à travers lequel celle-ci s'étend). De façon analogue, on appelle « largeur » la dimension de l'attache selon une direction perpendiculaire à la direction longitudinale. Sur les figures 1A et 1B, la longueur de l'attache 3 correspond à la dimension selon l'axe y et sa largeur correspond à la dimension selon l'axe x.

Dans l'exemple de réalisation illustré par les figures 1A et 1B, la largeur de l'attache 3 diminue de façon continue depuis son extrémité de liaison au reste de la plaque 2 jusqu'à son extrémité de liaison au composant horloger 1. On pourrait toutefois envisager d'autres formes d'attache 3, notamment une attache de largeur constante, avec éventuellement un rétrécissement à proximité de l'extrémité de liaison au composant.

Sur les figures 1A, 1B et 1C, le composant horloger 1 représenté est un spiral (seule une moitié du spiral, du centre au bord, étant représentée sur la figure 1B et 1C). Bien évidemment, le procédé de l'invention s'applique à la fabrication d'autres composants horlogers. Le composant horloger peut être une entité prête à être montée dans un mouvement (par exemple une aiguille, un ressort, etc.) ou une pièce destinée à être assemblée à une ou plusieurs autres pièces (par exemple un spiral à l'axe de balancier, une planche de roue à son axe, une ancre à la tige (ou axe) d'ancre, un balancier à l'axe de balancier, etc) avant montage.

L'étape S3 consiste à réaliser, pour chaque attache 3, le long d'une ligne de rupture souhaitée de l'attache 3, une zone de pré-détachage 4.

Par « ligne de rupture », on entend désigner une ligne dans le plan de la plaque le long de laquelle la rupture du matériau est souhaitée lors de la libération du composant 1 de la plaque 2. La ligne de rupture comprend ici un segment droit s'étendant dans le sens de la largeur de l'attache 3 (c'est-à-dire selon la direction x), et sur la totalité de la largeur de l'attache 3, à l'extrémité de liaison de l'attache 3 au composant 1. On pourrait évidemment envisager d'autres formes de ligne de rupture et d'autres emplacements (par exemple au milieu de l'attache, ou à l'extrémité de liaison avec la plaque).

La zone de pré-détachage 4 s'étend le long de la ligne de rupture, à l'extrémité de liaison de l'attache 3 au composant horloger 1, sur toute la largeur de l'attache 3 (selon la direction x sur la figure 1A). La longueur de la zone de pré-détachage 4, c'est-à-dire sa dimension le long de la ligne de rupture (soit selon la direction x sur la figure 1A), est par exemple comprise entre 20 et 150 µm.

Dans l'exemple de réalisation représenté sur les figures 1A et 1B, pour réaliser la zone de pré-détachage 4, on grave une ouverture 5 qui s'étend de façon continue le long de la totalité de la ligne de rupture et traverse ainsi l'attache 3 dans le sens de sa largeur. L'ouverture 5 a la forme d'une tranchée s'étendant selon la direction x et ayant une section transversale en U droit (figure 1B).

La profondeur de la tranchée 5 est par exemple égale à environ 75% de l'épaisseur totale de la plaque (ou du composant) et sa largeur (c'est-à-dire sa dimension selon la direction y) est par exemple de l'ordre de 4 µm. La profondeur et la largeur de la tranchée 5 pourraient évidemment avoir d'autres valeurs. Par exemple, la profondeur peut être supérieure ou égale à la moitié de l'épaisseur de la plaque (ou du composant) et inférieure ou égale à 90% de l'épaisseur de la plaque (ou du composant), préférentiellement inférieure ou égale à 60% de ladite épaisseur. La largeur peut être supérieure ou égale à 1 µm et inférieure ou égale à 10 µm, préférablement inférieure à 5 µm.

La gravure du composant horloger 1 (« DRIE_1 ») et la gravure de l'ouverture 5 (« DRIE_3 ») de la zone de pré-détachage 4 peuvent être réalisées de façon simultanée par gravure ionique réactive profonde (DRIE).

L'ouverture 5 permet de créer dans l'attache 3, à l'extrémité de liaison de l'attache 3 au composant 1, une zone de plus faible résistance mécanique (c'est-à-dire la zone de pré-détachage 4) et d'amorcer la rupture à l'endroit souhaité sur le composant 1.

L'étape S4 consiste à libérer le composant horloger 1 de la plaque 2, par rupture ou casse des attaches 3 le long de leur ligne de rupture. La rupture peut être provoquée en exerçant sur l'attache 3 une force mécanique dans une direction perpendiculaire, ou sensiblement perpendiculaire, au plan de la plaque (correspondant à la direction z sur les figures 1A et 1B). Par «sensiblement perpendiculaire », on entend désigner une direction présentant un angle de plus ou moins 10° par rapport à la direction perpendiculaire à la plaque (ou perpendiculaire au plan de la plaque). En variante, on provoque la rupture en exerçant sur l'attache 3 une force mécanique selon une direction présentant un angle inférieur ou égal à 45° par rapport à une direction perpendiculaire à la plaque, notamment inférieur ou égal à 30° par rapport à une direction perpendiculaire à la plaque. Le matériau de la plaque 1 étant un matériau fragile, n'ayant pas de domaine de déformation plastique, la force appliquée perpendiculairement, ou sensiblement perpendiculairement, ou bien selon une direction proche de la perpendiculaire à la plaque, a pour effet de casser le matériau au niveau de la zone de pré-détachage 4, le long de la ligne de rupture. La rupture est facilitée et contrôlée grâce à la zone de pré-détachage 4. On pourrait également envisager de libérer le composant 1 de la plaque 2 en complétant la gravure de l'attache au niveau de la zone de pré-détachage 4 par un traitement laser, notamment avec un équipement laser à impulsions femtosecondes.

La rupture par sollicitation mécanique dans une direction perpendiculaire au plan de la plaque, autrement dit par une traction ou une torsion suivant la direction z, est simple à mettre en œuvre et favorable pour réaliser des composants, notamment des spiraux ou des roues. A contrario, la rupture par sollicitation mécanique dans un plan de la plaque, autrement dit par une torsion suivant une direction contenue dans le plan x-y, par exemple en sollicitant une articulation, ne serait pas pratique à mettre en œuvre. En effet, cela nécessiterait de prévoir de la place autour du composant pour permettre le déplacement des éléments, cette place ne pouvant pas conséquent pas être utilisée pour la réalisation d'autres composants.

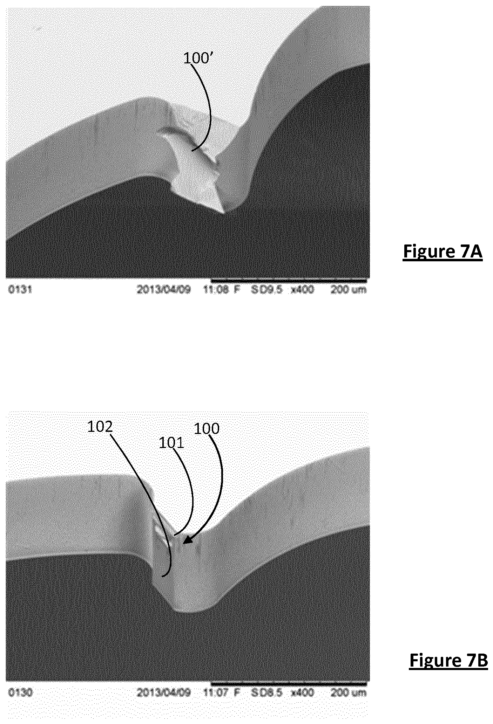

Le composant horloger libéré 1 comporte, sur sa tranche, une surface de rupture 100, telle que représentée à titre d'exemple illustratif sur la figure 7B. Cette surface 100 comporte deux parties adjacentes distinctes, l'une 102 gravée et l'autre 101 rompue. La partie 102 correspond à l'une des parois latérales en U de l'ouverture 5 gravée, alors que la partie 101 correspond au fond du U rompu. Sur la figure 7A, à des fins de comparaison, on a représenté une surface de rupture 100' obtenue avec une attache selon l'art antérieur, sans zone de pré-détachage 4. On constate que la surface de rupture 100 de la figure 7B est plus nette, plus propre et moins étendue que la surface de rupture 100'.

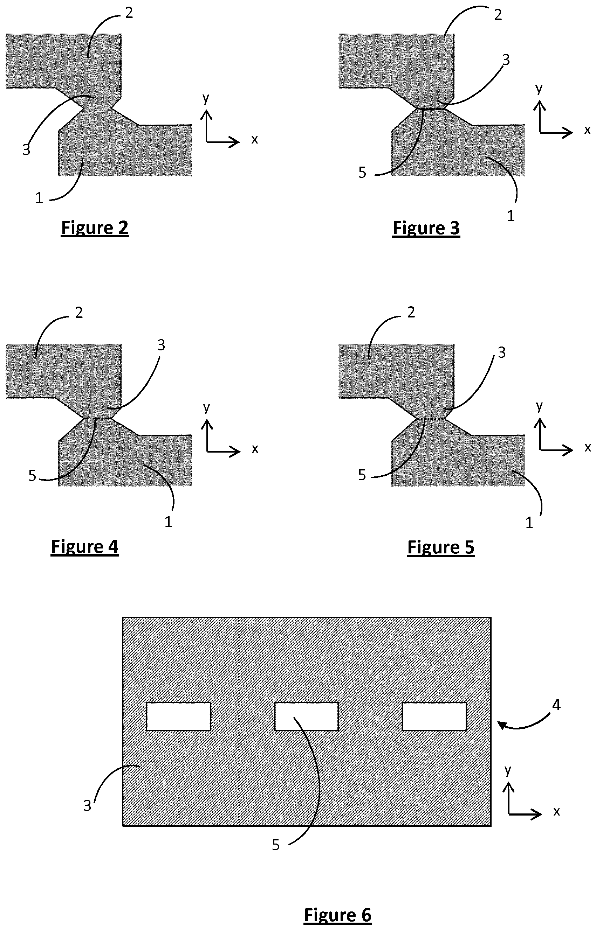

On peut envisager différentes formes de réalisation de la zone de pré-détachage 4. Sur les figures 3, 4 et 5, on a représenté schématiquement trois exemples de réalisation distincts. Par souci de clarté, les éléments analogues ou correspondants représentés sur les différentes figures portent les mêmes références.

Sur la figure 3, la zone de pré-détachage 4 comprend une ouverture 5 sous la forme d'une tranchée qui s'étend à l'extrémité de liaison de l'attache 3 au composant 1, sur toute la largeur de l'attache 3, le long d'une ligne de rupture droite. Il s'agit d'une forme de réalisation analogue à celle des figures 1A et 1B.

Sur les figures 4 et 5, la zone de pré-détachage 4 comprend une pluralité d'ouvertures gravées 5 alignées le long de la ligne de rupture (celle-ci n'étant pas représentée par souci de clarté, mais étant analogue à celle de la figure 3) et séparées par des ponts non gravés. Les ponts et les ouvertures 5 sont ici de même longueur. Ils pourraient évidemment être de longueurs différentes. Les ouvertures 5 sont de forme parallélépipédique. Elles peuvent être borgnes, c'est-à-dire gravées dans une partie de l'épaisseur de la plaque, ou traversantes, c'est-à-dire gravées dans la totalité de l'épaisseur de la plaque. Les formes de réalisation des figures 4 et 5 diffèrent par les dimensions des ouvertures 5. Sur la figure 4, les ouvertures 5 ont une largeur (selon la direction y) de 2 µm et une longueur (selon la direction x) de 10 µm. Sur la figure 5, les ouvertures 5 ont une largeur (selon la direction y) de 2 µm et une longueur (selon la direction x) de 2 µm. Bien entendu, les dimensions et formes des ouvertures 5 pourraient être différentes. Les dimensions des ouvertures 5 alignées le long de la ligne de rupture peuvent par exemple être comme suit :
- longueur (le long de la ligne de rupture) comprise entre 2 µm et 10 µm ;
- largeur comprise entre 1 µm et 5 µm ;
- profondeur supérieure ou égale à la moitié de l'épaisseur de la plaque.

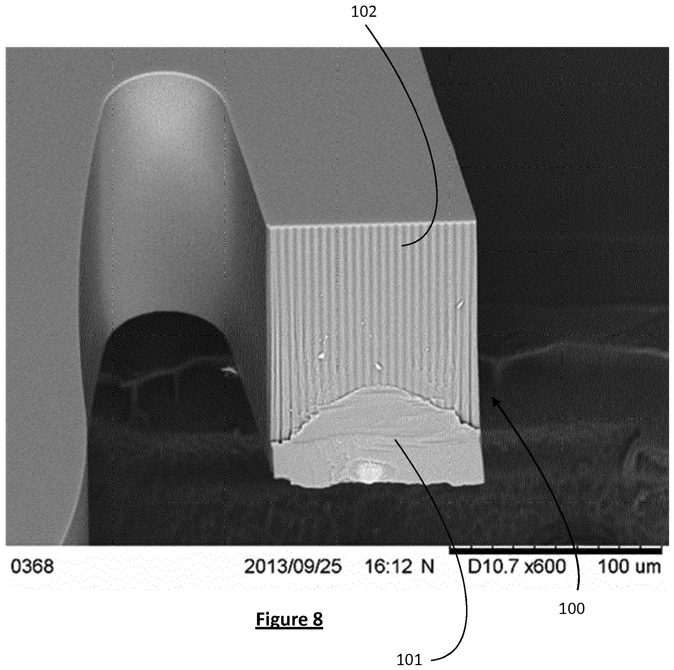

Sur la figure 8, on a représenté, à titre d'exemple illustratif, une zone de rupture 100 obtenue avec une zone de pré-détachage 4 comportant une pluralité d'ouvertures 5 alignées le long d'une ligne de rupture et ayant les caractéristiques suivantes :
- largeur de l'attache 3 à l'extrémité de liaison au composant 1 de 100µm,
- largeur des ouvertures de pré-détachage 5 de 4 µm ;
- longueur des ouvertures de pré-détachage 5 de 2 µm ;
- espace inter-ouvertures de 2 µm ;
- profondeur des ouvertures 5 égale à environ 80% de l'épaisseur totale de la plaque.

Dans ce cas, la zone de rupture 100 comprend une partie rompue 101 (c'est-à-dire une surface de rupture obtenue par rupture du matériau) et une partie 102 comportant une succession alternée de rainures gravées et de rainures rompues, disposées verticalement. Les deux parties 101 et 102 sont disposées l'une au-dessous de l'autre selon l'épaisseur du composant 1. Notons que sur la figure 8, la frontière entre la partie rompue 101 et la partie rainurée 102 est courbe du fait que la vitesse de gravure n'est pas égale sur toute la longueur de la ligne de rupture, les zones situées près des extrémités de cette ligne de rupture étant attaquées plus rapidement qu'au centre.

Dans la description qui précède, le composant horloger 1 et la ou les ouvertures 5 sont gravées en même temps. En variante, la gravure de la ou des ouvertures 5 et celle du composant horloger 1 peuvent être réalisées séparément. Dans ce cas, la ou les ouvertures peuvent être réalisées par diverses techniques d'ablation, par exemple par gravure DRIE, par ablation à l'aide d'impulsions femtosecondes émises par un équipement laser, par ablation mécanique (scie diamantée), ou autre. Préférentiellement, le composant horloger 1 et la ou les ouvertures 5 sont gravées en même temps.

Pour graver séparément le composant horloger 1 et l'ouverture (ou les ouvertures) 5 de la zone de pré-détachage, on peut prévoir deux étapes de masquage. Dans ce cas, une première étape de masquage est réalisée pour graver la ou les ouvertures 5 de la zone de pré-détachage 4. Une deuxième étape de masquage est ensuite réalisée pour graver le composant horloger 1 et ses attaches 3, tout en protégeant la ou les ouvertures 5. On pourrait également envisager l'inverse, c'est-à-dire faire un premier masquage pour graver les ouvertures traversantes permettant de former le composant horloger 1 et ses attaches 3, puis un deuxième masquage pour graver la ou les ouvertures de pré-détachage 5 tout en protégeant les ouvertures traversantes. Le masquage peut consister en un masquage mécanique ou un masquage réalisé par photolithographie d'une résine photosensible.

Dans le cas d'une gravure simultanée du composant horloger 1 et de la ou des ouvertures de pré-détachage 5, la profondeur de la ou des ouverture(s) 5 dépend de différents paramètres relatifs à la gravure du composant horloger, notamment la vitesse d'attaque du dispositif de gravure DRIE et la durée de l'attaque. En outre, la profondeur de la ou des ouverture(s) 5 dépend également de la largeur et de la longueur de cette ou ces ouverture(s) 5. En toute hypothèse, dans ce cas, la durée d'attaque par le dispositif de gravure est la même pour réaliser à la fois les ouvertures destinées à former le composant et la ou des ouverture(s) de pré-détachage 5, de façon simultanée. Il est donc préférable que la largeur des ouvertures de pré-détachage 5 soit inférieure à la largeur des ouvertures traversantes formant le composant horloger, ou, dans le cas où les ouvertures traversantes formant le composant horloger présentent des largeurs différentes les unes des autres, inférieure à la plus petite des largeurs des ouvertures traversantes formant le composant horloger. En particulier, si la largeur des ouvertures traversantes formant le composant est supérieure à 40 µm, et/ou est contenue dans une plage de valeurs comprise entre 40 µm et 100µm, ou est supérieure à 100 µm, la largeur des ouvertures de pré-détachage 5 sera avantageusement entre 1 et 10 µm, voire entre 1 et 5 µm. Ainsi, dans le cas où les ouvertures traversantes destinées à former le composant horloger et la ou les ouverture(s) de pré-détachage sont réalisées simultanément, la largeur choisie pour la ou les ouverture(s) de pré-détachage 5 selon l'invention dépend en définitive de la plus petite des largeurs des ouvertures traversantes formant le composant horloger et de la profondeur souhaitée pour la ou les ouverture(s) de pré-détachage. De plus, la largeur de la ou des ouverture(s) de pré-détachage peut dépendre de particularités du procédé et/ou de l'équipement de gravure DRIE utilisé. L'homme du métier saura effectuer les tests d'ajustement nécessaires pour déterminer la largeur optimale des ouvertures de pré-détachage 5.

Le procédé peut également comprendre des étapes supplémentaires de traitement, réalisées avant ou après libération du composant, telles qu'un amincissement préalable de la plaque de matériau micro-usinable (pour réduire son épaisseur), un dépôt de revêtement, un traitement thermique d'oxydation, un nettoyage/dégraissage, etc.

On va maintenant décrire différentes formes ou variantes de réalisation de la zone de pré-détachage en référence aux figures 10A à 10F. Sur ces figures, la ligne de rupture le long de laquelle s'étend la zone de pré-détachage est notée « L ».

Dans le cas d'une zone de pré-détachage comportant une ouverture continue 5, du type de celle représentée sur les figures 1A et 1B, on pourrait graver une ouverture de pré-détachage 5 de largeur variable le long de la ligne de rupture. Dans ce cas, cela permet de faire varier également la profondeur de l'ouverture le long de la ligne de rupture, notée L, comme représenté sur les figures 10A et 10B, qui représentent respectivement une vue de dessus d'une attache 3 entre la plaque 2 et le composant 1 et une vue zoomée en coupe dans le plan défini par les axes x et z, de l'ouverture de pré-détachage 5.

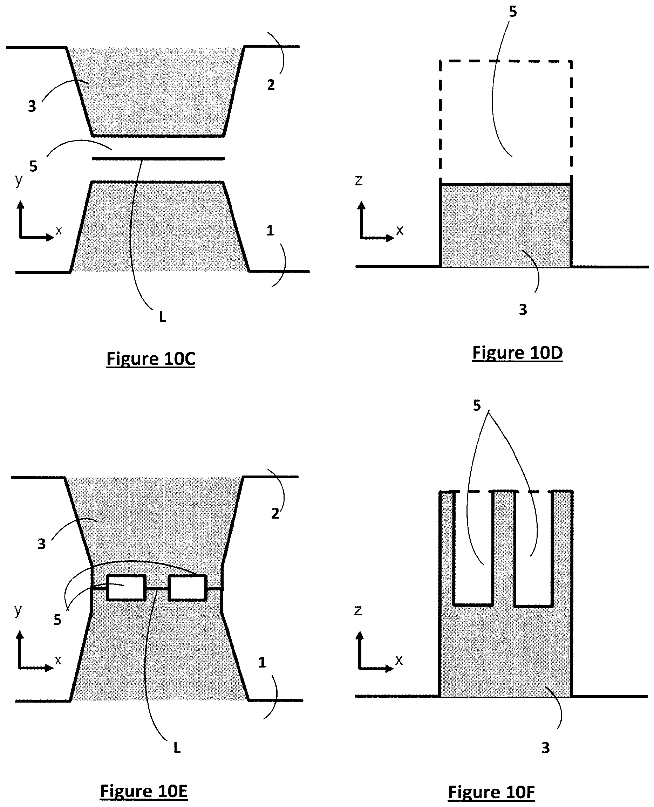

A titre de comparaison les figures 10C et 10D représentent respectivement une vue de dessus d'une attache 3 entre la plaque 2 et le composant 1 et une vue zoomée en coupe dans le plan défini par les axes x et z de l'ouverture de pré-détachage 5, conforme à la première forme de réalisation dans laquelle la largeur et la profondeur de l'ouverture de pré-détachage 5 sont constantes le long de la ligne de rupture L.

Les figures 10E et 10F représentent respectivement une vue de dessus d'une attache 3 entre la plaque 2 et le composant 1 et une vue zoomée en coupe dans le plan défini par les axes x et z, de l'ouverture de pré-détachage 5, conforme à la deuxième forme de réalisation dans laquelle la zone de pré-détachage comporte une pluralité d'ouvertures alignées le long de la ligne de rupture L.

La présence d'une ligne de rupture est avantageuse car elle permet de déterminer précisément la localisation et l'étendue de la surface de rupture. Ceci n'est pas le cas si on utilise une technique connue de l'art antérieur consistant, par exemple, à prévoir un simple pont de matière ou un pont de matière de moindre largeur et/ou de moindre épaisseur. Dans ce cas, l'endroit de la rupture n'est pas précisément déterminé. Il peut se trouver quelque part le long du pont de matière affaibli, et peut aussi bien être proche du composant que du reste de la plaque. Il en résulte une incertitude sur la localisation de la rupture. De plus, dans certains cas, la rupture dégrade l'aspect esthétique du composant, voire même son efficacité de fonctionnement, ce qui s'avère particulièrement gênant.

L'invention concerne aussi un composant horloger présentant une zone de rupture partiellement gravée. Par « zone de rupture », on entend désigner la portion de tranche du composant (sur toute l'épaisseur du composant) contenant une ou plusieurs surfaces de rupture. Selon le mode de réalisation du procédé de fabrication du composant, la zone de rupture peut comprendre :
- une partie entièrement gravée et une partie entièrement rompue disposées l'une au-dessus de l'autre (selon l'épaisseur du composant) ;
- une partie comportant une succession alternée de rainures gravées et de rainures rompues, et une partie entièrement rompue, disposées l'une au-dessus de l'autre (selon l'épaisseur du composant);
- une succession alternée de rainures gravées et de rainures rompues (sur toute l'épaisseur du composant).

## Revendications

1. Procédé de fabrication d'un composant horloger (1) comportant les étapes suivantes :
• se munir (S1) d'une plaque (2) en un matériau micro-usinable ;
• former (S2) le composant horloger (1) avec au moins une attache (3) de maintien au reste de la plaque (2), par gravure de la plaque (2) ;
**caractérisé par le fait qu'**il comprend une étape (S3) consistant à réaliser, le long d'une ligne (L) de rupture souhaitée de l'attache, une zone de pré-détachage (4) comportant au moins une ouverture (5) obtenue par gravure dans l'épaisseur de la plaque (2), la profondeur de la au moins une ouverture (5) étant inférieure ou égale à 90% de l'épaisseur de la plaque (2), préférentiellement inférieure ou égale à 60% de ladite épaisseur, et supérieure ou égale à la moitié de l'épaisseur de la plaque (2).

2. Procédé selon la revendication 1, **caractérisé en ce que** le composant horloger (1) est formé par gravure de la plaque (2) dans toute son épaisseur.

3. Procédé selon l'une des revendications 1 à 2, **caractérisé en ce que** ladite ouverture (5) s'étend le long de la totalité de la ligne de rupture (L).

4. Procédé selon l'une des revendications 1 à 2, **caractérisé en ce que** la zone de pré-détachage (4) comporte une pluralité d'ouvertures (5) alignées le long de la ligne de rupture (L).

5. Procédé selon la revendication précédente, **caractérisé en ce que** les ouvertures (5) alignées le long de la ligne de rupture sont séparées par des ponts non gravés.

6. Procédé selon l'une des revendications précédentes, **caractérisé en ce que** la gravure du composant horloger (1) et la gravure de l'ouverture (5) de la zone de pré-détachage (4) sont réalisées de façon simultanée.

7. Procédé selon la revendication précédente, **caractérisé en ce que** la largeur de ladite ouverture (5) de la zone de pré-détachage (4) est inférieure à la largeur d'une ouverture traversante destinée à former le composant horloger, notamment inférieure à la plus petite des largeurs d'une pluralité d'ouvertures traversantes formant le composant horloger.

8. Procédé selon l'une des revendications 6 et 7, **caractérisé en ce que** ladite largeur d'ouverture traversante destinée à former le composant étant supérieure à 40 µm, la largeur ladite ouverture (5) de la zone de pré-détachage (4) est comprise entre 1 et 10 µm, notamment entre 1 et 5 µm.

9. Procédé selon l'une des revendications précédentes, **caractérisé en ce que** la gravure du composant horloger (1) et la gravure de l'ouverture (5) de la zone de pré-détachage (4) sont réalisées par gravure ionique réactive profonde.

10. Procédé selon l'une des revendications précédentes, **caractérisé en ce que** le matériau de la plaque (2) est un matériau fragile, notamment l'un des matériaux du groupe comportant le silicium, le diamant, le quartz et la céramique.

11. Procédé selon l'une des revendications précédentes, **caractérisé en ce qu'**il comprend une étape (S4) de libération du composant horloger (1) par rupture de l'attache (3) le long de la ligne de rupture (L).

12. Procédé selon la revendication précédente, **caractérisé en ce que**, lors de l'étape (S4) de libération du composant horloger, on provoque la rupture en exerçant sur l'attache (3) une force mécanique selon une direction présentant un angle inférieur ou égal à 45° par rapport à une direction perpendiculaire à la plaque, notamment inférieur ou égal à 30° par rapport à une direction perpendiculaire à la plaque, préférentiellement selon une direction perpendiculaire, ou sensiblement perpendiculaire, à la plaque.

13. Procédé selon l'une des revendications précédentes, **caractérisé en ce que** le composant horloger (1) est l'un des éléments du groupe comportant un spiral, une roue, une aiguille, un ressort, une ancre et un balancier.

14. Plaque en matériau micro-usinable comportant un composant horloger (1) et au moins une attache (3) de maintien entre le composant horloger (1) et le reste de la plaque (2), formés par des ouvertures gravées dans l'épaisseur de la plaque (2), **caractérisée par le fait qu'**elle comprend une zone (4) de pré-détachage du composant horloger (1) comportant, le long d'une ligne (L) de rupture souhaitée de l'attache (3), au moins une ouverture (5) gravée dans l'épaisseur de la plaque (2), la profondeur de la au moins une ouverture (5) étant inférieure ou égale à 90% de l'épaisseur de la plaque (2), préférentiellement inférieure ou égale à 60% de ladite épaisseur, et supérieure ou égale à la moitié de l'épaisseur de la plaque (2).

## Patentansprüche

1. Verfahren zur Herstellung eines Uhrenbauteils (1), umfassend die folgenden Schritte:
- Bereitstellen (S1) einer Platte (2) aus einem mikro-bearbeitbarem Material;
- Bilden (S2) des Uhrenbauteils (1) mit mindestens einem Befestigungselement (3) zum Halt am Rest der Platte (2) durch Gravur der Platte (2);
**dadurch gekennzeichnet, dass** es einen Schritt (S3) umfasst, der darin besteht, entlang einer gewünschten Sollbruchlinie (L) des Befestigungselements einen Bereich der Vor-Ablösung (4) zu schaffen, umfassend mindestens eine Öffnung (5), die durch Gravur in der Stärke der Platte (2) erhalten wird, wobei die Tiefe der wenigstens einen Öffnung (5) kleiner oder gleich 90% der Stärke der Platte (2) bemisst, vorzugsweise kleiner oder gleich 60% der genannten Stärke und größer oder gleich der Hälfte der Stärke der Platte (2).

2. Verfahren gemäß Anspruch 1, **dadurch gekennzeichnet, dass** das Uhrenbauteil (1) durch Gravur der Platte (2) in ihrer ganzen Stärke gebildet wird.

3. Verfahren gemäß einem der Ansprüche 1 bis 2, **dadurch gekennzeichnet, dass** die genannte Öffnung (5) sich entlang der gesamten Sollbruchlinie (L) erstreckt.

4. Verfahren gemäß einem der Ansprüche 1 bis 2, **dadurch gekennzeichnet, dass** der Bereich der Vor-Ablösung (4) eine Vielzahl an Öffnungen (5) umfasst, die entlang der Sollbruchlinie (L) ausgerichtet sind.

5. Verfahren gemäß dem vorangehenden Anspruch, **dadurch gekennzeichnet, dass** die entlang der Sollbruchlinie ausgerichteten Öffnungen (5) durch nicht gravierte Punkte getrennt sind.

6. Verfahren gemäß einem der vorangehenden Ansprüche, **dadurch gekennzeichnet, dass** die Gravur des Uhrenbauteils (1) und die Gravur der Öffnung (5) des Bereichs der Vor-Ablösung (4) gleichzeitig erfolgen.

7. Verfahren gemäß dem vorangehenden Anspruch, **dadurch gekennzeichnet, dass** die Weite der genannten Öffnung (5) des Bereichs der Vor-Ablösung (4) geringer ist als die Weite einer durchgehenden Öffnung zur Bildung eines Uhrenbauteils, insbesondere geringer als die geringste der Weiten einer Vielzahl von durchgehenden Öffnungen, die das Uhrenbauteil bilden.

8. Verfahren gemäß einem der Ansprüche 6 und 7, **dadurch gekennzeichnet, dass** die genannte Weite der durchgehenden Öffnung, die zur Bildung des Bauteils vorgesehen ist größer als 40 µm ist, die Weite der genannten Öffnung (5) des Bereichs zur Vor-Ablösung (4) zwischen 1 und 10 µm beträgt, insbesondere zwischen 1 und 5 µm.

9. Verfahren gemäß einem der vorangehenden Ansprüche, **dadurch gekennzeichnet, dass** die Gravur des Uhrenbauteils (1) und die Gravur der Öffnung des Bereichs der Vor-Ablösung (4) durch ein reaktives lonenätzverfahren erfolgen.

10. Verfahren gemäß einem der vorangehenden Ansprüche, **dadurch gekennzeichnet, dass** das Material der Platte (2) ein sprödes Material ist, insbesondere ein Material aus der Gruppe umfassend Silizium, Diamant, Quarz und Keramik.

11. Verfahren gemäß einem der vorangehenden Ansprüche, **dadurch gekennzeichnet, dass** es einen Schritt (S4) umfasst zur Freilegung des Uhrenbauteils (1) durch einen Bruch des Befestigungselements (3) entlang der Sollbruchlinie (L).

12. Verfahren gemäß dem vorangehenden Anspruch, **dadurch gekennzeichnet, dass**, während des Schrittes (S4) zur Freilegung des Uhrenbauteils, der Bruch durch Ausüben einer mechanischen Kraft auf das Befestigungselement (3) entlang einer Richtung provoziert wird, die einen Winkel kleiner oder gleich 45° bildet in Bezug auf eine Richtung rechtwinklig zur Platte, insbesondere kleiner oder gleich 30° in Bezug auf eine Richtung rechtwinklig zur Platte, bevorzugt entlang einer Richtung senkrecht oder im Wesentlichen senkrecht zur Platte.

13. Verfahren gemäß einem der vorangehenden Ansprüche, **dadurch gekennzeichnet, dass** das Uhrenbauteil (1) eines der Elemente ist aus der Gruppe umfassend eine Spiralfeder, ein Zahnrad, einen Zeiger, eine Feder, einen Anker und eine Unruh.

14. Platte aus mikro-bearbeitbarem Material umfassend ein Uhrenbauteil (1) und mindestens ein Befestigungselement (3) zum Halt zwischen Uhrenbauteil (1) und dem Rest der Platte (2), gebildet durch gravierte Öffnungen in der Stärke der Platte (2), **gekennzeichnet dadurch, dass** sie einen Bereich (4) der Vor-Ablösung des Uhrenbauteils (1) umfasst, enthaltend, entlang einer gewünschten Sollbruchlinie (L) des Befestigungselements (3) mindestens eine Öffnung (5) graviert in der Stärke der Platte (2), wobei die Tiefe der mindestens einen Öffnung (5) kleiner oder gleich 90% der Stärke der Platte (2) bemisst, bevorzugt kleiner oder gleich 60% der genannten Stärke und größer oder gleich der Hälfte der Stärke der Platte (2).

## Claims

1. A method for manufacturing a horology component (1), comprising the following steps:
• procuring (S1) a sheet (2) of a micromachinable material;
• forming (S2) the horology component (1) with at least one attachment (3) tethering it to the rest of the sheet (2), by etching the sheet (2);
**characterized in that** the method comprises a step (S3) consisting in creating, along a line (L) of desired fracture of the attachment, a predetachment zone (4) comprising at least one opening (5) obtained by etching into the thickness of the sheet (2), the depth of the at least one opening (5) being less than or equal to 90% of the thickness of the sheet (2), preferably less than or equal to 60% of said thickness, and greater than or equal to half the thickness of the sheet (2).

2. The method as claimed in claim 1, **characterized in that** the horology component (1) is formed by etching the sheet (2) throughout its entire thickness.

3. The method as claimed in one of claims 1 to 2, **characterized in that** said opening (5) extends along the entirety of the fracture line (L).

4. The method as claimed in one of claims 1 to 2, **characterized in that** the predetachment zone (4) comprises a plurality of openings (5) aligned along the fracture line (L).

5. The method as claimed in the preceding claim, **characterized in that** the plurality of openings (5) aligned along the fracture line are separated by non-etched bridges.

6. The method as claimed in one of the preceding claims, **characterized in that** the etching of the horology component (1) and the etching of the opening (5) of the predetachment zone (4) are performed simultaneously.

7. The method as claimed in the preceding claim, **characterized in that** the width of said opening (5) of the predetachment zone (4) is less than the width of a through-opening intended to form the horology component, notably less than the smallest of the widths of a plurality of through-openings forming the horology component.

8. The method as claimed in one of claims 6 and 7, **characterized in that**, with said width of through-opening intended to form the component being greater than 40 µm, the width of said opening (5) of the predetachment zone (4) is comprised between 1 and 10 µm, notably between 1 and 5 µm.

9. The method as claimed in one of the preceding claims, **characterized in that** the etching of the horology component (1) and the etching of the opening (5) of the predetachment zone (4) are performed using deep reactive ion etching.

10. The method as claimed in one of the preceding claims, **characterized in that** the material of the sheet (2) is a brittle material, notably one of the materials from the group containing silicon, diamond, quartz and ceramic.

11. The method as claimed in one of the preceding claims, **characterized in that** it also comprises a step (S4) of freeing the horology component (1) by fracturing the attachment (3) along the fracture line (L).

12. The method as claimed in the preceding claim, **characterized in that**, during the step (S4) of freeing the horology component, fracture is brought about by applying a mechanical force to the attachment (3) in a direction that is at an angle less or equal to 45° with respect to a direction perpendicular to the sheet, notably less or equal to 30° with respect to a direction perpendicular to the sheet, preferably in a direction perpendicular or substantially perpendicular to the sheet.

13. The method as claimed in one of the preceding claims, **characterized in that** the horology component (1) is one of the elements from the group comprising a balance spring, a wheel, a hand, a spring, a pallet and a balance-wheel.

14. A sheet of micromachinable material comprising a horology component (1) and at least one attachment (3) tethering the horology component (1) to the rest of the sheet (2), these being formed by openings etched into the thickness of the sheet (2), **characterized in that** it it also comprises a zone (4) for predetachment of the horology component (1) comprising, along a line (L) of desired fracture of the attachment (3), at least one opening (5) etched into the thickness of the sheet (2), the depth of the at least one opening (5) being less than or equal to 90% of the thickness of the sheet (2), preferably less than or equal to 60% of said thickness, and greater than or equal to half the thickness of the sheet (2).
